# EUROPEAN PATENT APPLICATION

(11) **EP 4 650 821 A1**
(43) Date of publication of application: **19.11.2025**
(21) Application number: 24176176.6
(22) Date of filing: 16.05.2024
(51) Int. Cl.: G01S 7/481, G01S 17/34, H01S 5/02, H01S 5/02326, G02B 6/12

(54) **HYBRID SILICON PHOTONIC INTEGRATED CIRCUIT FOR AN FMCW LIDAR DEVICE AND MANUFACTURING METHOD**

(71) Applicant: Scantinel Photonics GmbH, 89077 Ulm (DE)
(72) Inventor: Aksarin, Stanislav, 76187 Karlsruhe (DE); Davydenko, Vladimir, 76332 Bad-Herrenalb (DE); Ganin, Denis, 89077 Ulm (DE); Hosseini, Naser, 1090 Jette (BE); Zott, Andy, 89547 Gerstetten (DE)
(74) Representative: Ostertag & Partner Patentanwälte mbB

(57) **Abstract**

A hybrid silicon photonic integrated circuit (48) for an FMCW LIDAR device (14), comprises a first SOI substrate (70) having a trench (80), a first optical waveguide (76) monolithically formed on or in the first SOI substrate (70) and abutting the trench (80), and a heterogeneously integrated laser chip (50) received upside down in the trench (80). A free-space coupler (36) is monolithically formed on or in the first SOI substrate (70), connected to the laser chip (50) via the first optical waveguide (76) and emits the light generated by the laser chip (50) into free space. A detector (32) is detects a superposition of reflected light, which was emitted by the free-space coupler (36) and reflected at an object (12) to which a range shall be measured, and reference light, which was not reflected at the object (12).

## Description

### BACKGROUND OF THE INVENTION

### 1. Field of the Invention

The invention relates to a device for scanning range - and preferably also velocity - measurement relative to a moving or unmoving object on the basis of FMCW LiDAR technology, and in particular to hybrid silicon photonic integrated circuit contained in such a device. FMCW LiDAR devices can be used, for example, in autonomously driving vehicles. The invention also relates to a method of manufacturing such a hybrid silicon photonic integrated circuit.

### 2. Description of Related Prior Art

Frequency-modulated continuous wave (FMCW) is a range and velocity measuring technology which was originally developed for RADAR applications. If light instead of radio waves are used, this technology is usually referred to as FMCW LiDAR, in which LiDAR is an acronym for "Light Detection And Ranging".

In FMCW LiDAR scanning devices, frequency-modulated light beams scan the environment. A small fraction of the light, which is diffusely reflected at an object, is received and superimposed with a local oscillator wave. The frequency difference between the two signals, which is usually referred to as beat frequency, is measured and used to compute the range of the object. By using a tunable laser as light source and a photodiode as detector, the beat frequency can be extracted directly from the photodiode current, because the photodiode delivers a current that is proportional to the squared sum of the two optical waves ("self-mixing effect"). If the Doppler shift is taken into account, the relative velocity between the scanning device and the object along the light propagation direction can be calculated, too.

Scanning devices based on this measurement principle must be very robust and reliable if they are to be used in vehicles. This is particularly true if the vehicles are to drive autonomously, since the safety of autonomous driving decisively depends on the scanning device that is used to generate a three-dimensional profile of the environment. On the other hand, keeping production costs low is crucial if such devices are to be commercially successful, given that a vehicle may need two, four or even more devices of this kind.

The most promising approach to meeting these requirements is to implement FMCW LiDAR scanning devices as photonic integrated circuits (PICs), which combine optical waveguides and various functional units such as laser, optical amplifiers, switches or detectors on a chip having the size of a thumbnail. Integration on a PIC offers advantages such as energy efficiency, robustness, weight reduction and low costs when produced in large quantities. Therefore, implementation as a PIC makes FMCW LiDAR devices particularly suitable for automotive applications.

PICs with many different waveguide material technologies have been investigated, including silicon (Si), silicon nitride (Si₃N₄), doped silicon dioxide (SiO₂), gallium arsenide (GaAs), indium phosphide (InP) and lithium niobate (LiNbO₃). The most prominent waveguide material technology is silicon. Usually, a silicon-on-insulator (SOI) substrate is used comprising a support made of crystalline silicon that is covered by an insulator, which is usually SiO₂. The SOI substrate supports a patterned silicon layer surrounded by air or another insulator such as SiO₂ and forming the optical waveguide cores. The benefit of the silicon technology is the availability of high-quality wafer scale thin silicon films, which can be patterned using mature fabrication processes. These processes have been developed in recent decades for the complementary metal-oxide-semiconductor technology (CMOS), which is used in foundries that manufacture integrated circuits for consumer electronics in very high volumes.

However, over the years, it also became clear that silicon cannot fulfill the needs for all applications that would benefit from PICs. For example, it is difficult to achieve lasers or optical amplifiers (SOAs) in silicon due to its indirect bandgap. Such lasers require III-V materials including alloys containing B, Al Ga or In (group III) and N, P, As or Sb (group V), for example InP or GaAs. It has turned out that advanced PICs may require the best possible performance of a large number of different photonic elements in a PIC to achieve the desired functionality, which may not be possible with a single waveguide material technology.

A solution to overcome this limitation is to integrate different material technologies into a single PIC or package. This approach has the benefit that each material can be used to provide the photonic element functionality for which it is best suited without compromising the functionalities of the other elements in the system. The integration of the different material technologies can be distinguished by two different integration processes, namely hybrid integration and heterogeneous integration.

Hybrid photonic integration refers to a well-established assembling scheme in which a finished photonic chip, e.g. an III-V semiconductor laser chip, is optically integrated with a silicon photonic. This process is generally performed at the packaging stage after the fabrication of the PIC and photonic device chips. The III-V chips can be mounted either directly on the top of the silicon photonic chip PIC or next to it.

One of the main advantages of this integration technique is that one can test and characterize the device that needs to be integrated prior to the integration process. This allows to select the best performing devices and discard non-functional components, which has a very positive impact on production yield. However, while hybrid integration is very attractive for small volume production, the alignment of the III-V chip and the integration process is usually time consuming and thus reduces throughput. This makes this process less attractive for high volume and low-cost production. Furthermore, the complicated hybrid integration process sometimes has a negative impact on the reliability of the assembled PIC.

We define heterogeneous integration as a technology in which two or more optical waveguides made of different materials, for example silicon and InP, are integrated in the same building block, for example a laser, a semiconductor amplifier or a modulator. In such a building block, there is a least one section in which these optical waveguides run parallel so that the light evanescently couples from one optical waveguide to the other optical waveguide. The two optical waveguides are arranged in different layers of the building block, i.e. one above the other. The light therefore propagates simultaneously in the two optical waveguides, while in hybrid devices the light propagates sequentially from one optical waveguide to the next optical waveguide.

Typically, the manufacture of a heterogeneously integrated device involves a transfer of non-silicon, unprocessed thin-film materials onto pre-processed silicon photonic substrates using wafer bonding techniques. Planar optical waveguide techniques are then applied to achieve specific optical functions. Wafer bonding is the process of connecting two or more substrates or wafers via physical or chemical interactions. The bonding is generally performed at the early- to midstages of fabrication of the chip. In subsequent steps, the functional III-V layer stack is lithographically patterned to realize the desired optical functionality.

The key benefit of heterogeneous integration is that it can provide functionalities similar to monolithic integration, resulting in high alignment accuracy and low losses when transitioning between different waveguide material technologies. Other benefits are reliable performance of the integrated photonic elements and the low cost due to economy of scale. Therefore, it is suited for high-volume applications.

A disadvantage of heterogeneous integration processes is that it does not allow for component-by-component modular testing before integration into more complex PICs. Thus, it is somewhat "all or nothing" with tight requirements on process control to improve the yield. If, for example, 20% of the III-V components are defective, at least 20% of the final PICs will be defective, too.

### SUMMARY OF THE INVENTION

It is an object of the present invention to provide a hybrid silicon photonic integrated circuit for an FMCW LIDAR device which is suitable for high volume and low-cost production and has an improved efficiency so that more of the light generated by the semiconductor laser couples out into free space.

This object is achieved, in accordance with the invention, by a hybrid silicon photonic integrated circuit (PIC) for an FMCW LIDAR device comprising a first SOI substrate having a trench, a first optical waveguide monolithically formed in or on the first SOI substrate and abutting the trench, and a heterogeneously integrated laser chip configured to generate light having a varying frequency. The laser chip is received upside down in the trench and comprises a second SOI substrate having a second optical waveguide monolithically formed on or in the second SOI substrate. The second optical waveguide is aligned and butt coupled to the first optical waveguide. The laser chip further comprises a stack of patterned functional III-V layers forming a semiconductor laser and supported by the second SOI substrate. The stack of patterned functional III-V layers has been bonded to the second SOI substrate by a wafer bonding process. The PIC further comprises a free-space coupler that is monolithically formed on or in the first SOI substrate, connected to the laser chip via the first optical waveguide and configured to emit the light generated by the laser chip into free space. A detector, which may be monolithically formed on or in the first SOI substrate or may be attached to the first SOI substrate by hybrid integration, is configured to detect a superposition of reflected light, which was emitted by the free-space coupler and reflected at an object to which a range shall be measured, and reference light, which was not reflected at the object.

The invention is based on the conception that heterogeneously integrated semiconductor lasers are perfectly suited for FMCW LiDAR devices, because they enable a narrow linewidth without complicated means (e.g. distributed feedback (DFB) gratings) for linewidth narrowing as they are required for usual III-V chips. Furthermore, such lasers have a high output power and good frequency tunability. In addition, the fabrication of heterogeneous integrated semiconductor lasers is more efficient and straightforward compared with the fabrication of DFB lasers.

Heterogeneously integrated semiconductor lasers with a high Q resonator operate in a narrow linewidth regime that is not compromised by back reflections. This allows to operate such lasers without using an optical isolator. This is an important advantage, because optical isolators cannot be manufactured using currently available CMOS fab processes and thus cannot be integrated in a PIC.

Receiving the laser chip in a trench formed in the first SOI substrate makes it possible to butt couple the two optical waveguides. Butt coupling allows a much higher coupling efficiency than prior art solutions that rely on grating couplers. While grating couplers have losses in the order of 3 dB, butt coupling allows to reduce the losses at the junction between the laser chip and the remaining PIC to about 1 dB.

Another important advantage of the invention is that the heterogeneous integration of the laser chip makes it possible to fabricate spot size convertors (SSCs) in the second optical waveguide that increase the mode field diameter. The spot size convertors may have a conventional design and typically comprise adiabatic tapers. If the first optical waveguide and the second optical waveguide each terminate at a spot size converter configured to enlarge a mode field diameter of light guided in the respective optical waveguide, the coupling efficiency can be further increased. Simultaneously, the large mode field diameter prevailing in the interspace between the laser chip and the side wall of the trench allows to relax the alignment accuracy significantly. More specifically, it is then possible to align the laser chip on the first SOI substrate passively. Being able to secure the laser chip on the remaining PIC without active alignment steps considerably simplifies the hybrid integration of the laser chip and has a very beneficial impact on costs and manufacturing time.

Preferably, the photonic integrated circuit comprises an electrical integrated circuit forming a calculation unit that is configured to determine the range to the object based on the superposition detected by the detector. Then the PIC integrates not only all optical components from the semiconductor laser to the free-space couplers, but also the electronic circuits for processing the electrical signals produced by the detector. Since the first SOI substrate is manufactured based on established CMOS technology that is also used for manufacturing integrated electronic circuits, both circuits can be manufactured on the same substrate using basically the same CMOS processes. Alternatively, the calculation unit can be realized on an external chip that is electrically connected to the detector of the PIC.

In an embodiment, the PIC comprises electrical contacts that are arranged at a bottom of the trench and establish an electrical connection to the laser chip. Since the laser chip is received upside down in the trench, this allows to electrically contact the stack of patterned functional III-V layers without a need for vias or additional wiring. The electrical contacts may simultaneously establish a mechanical connection between the laser chip and the first SOI substrate.

In an embodiment, alignment structures are provided that are configured to passively align the laser chip in the trench of the first SOI substrate. While passive alignment may also be possible without additional alignment structures (e.g., by directly abutting the laser chip to walls of the trench), it is often preferred to use additional structures that are specifically designed for alignment purposes. For example, the alignment structures may be pedestals elevated from a bottom of the trench so that the laser chip can rest on the pedestals. Such pedestals are helpful to align the laser chip in a vertical direction and allows the provision of electrical contacts to be placed in the interspace between the bottom of the trench and the laser chip.

In an embodiment, a laser waveguide is formed in the stack of patterned functional III-V layers and evanescently coupled to the second optical waveguide. The term "evanescent coupling" is used here as a generic term and thus includes adiabatic coupling, which uses tapered structures, and diffractive coupling, which uses grating structure.

A first fiducial may be provided on the first SOI substrate and a second fiducial on the second SOI substrate, wherein the first fiducial is aligned with the second fiducial. Such fiducials are helpful if a purely passive alignment is not sufficient.

In an embodiment, the photonic integrated circuit comprises a heterogeneously integrated semiconductor optical amplifier chip configured to amplify light generated by the laser chip. The optical amplifier chip is received upside down in the same trench as the laser chip or in a different trench that is also formed in the first SOI substrate. The semiconductor optical amplifier chip comprises a third SOI substrate having a third optical waveguide that is monolithically formed on or in the third SOI substrate, the third optical waveguide being aligned and butt coupled to the first optical waveguide. The amplifier chip further comprises a further stack of patterned functional III-V layers forming a semiconductor optical amplifier and supported by the third SOI substrate, wherein the further stack of patterned functional III-V layers has been bonded to the third SOI substrate by a wafer-bonding process.

The same concept described above in the context of a semiconductor laser can also be applied to a semiconductor optical amplifier (SOA). Similar advantages are available for SOAs. For example, heterogeneously integrated SOA chips have a gain, a noise figure and an output power that are better controllable as compared to conventional chips, as the heterogeneously integrated SOA may be designed with lower confinement factor, enabling propagation of the optical mode mainly in a low absorption optical waveguide of the SOI substrate.

The semiconductor optical amplifier chip may have an input port, which is connected to the first optical waveguide, and a plurality of passive light splitters connecting the input port with a plurality of semiconductor optical amplifiers. This makes it possible to receive, via the input port, light that has been produced by the laser chip, was butt coupled into the first optical waveguide, and then butt coupled into the amplifier chip for amplification. Each optical channel, or groups of optical channels, of the LiDAR device may have their own SOA, wherein all SOAs are combined on the same SOA chip.

In embodiments that a not subject of the claims, the hybrid silicon photonic integrated circuit comprises a conventional III-V laser chip which is not heterogeneously integrated, and only the SOA chip is heterogeneously integrated. Conventional hybrid integration is used for connecting both chips to the PIC substrate.

Subject of the invention is also an FMCW LIDAR device for measuring the range to an object comprising the photonic integrated circuit as described in the foregoing and a collimating optical system having a front focal plane in which the plurality of free-space couplers are arranged.

Subject of the present invention is also a method of manufacturing a hybrid silicon photonic integrated circuit for an FMCW LIDAR device. The method comprises the following steps:
a) providing a first SOI substrate;
b) forming a first optical waveguide on or in the first SOI substrate;
c) forming a trench in the SOI substrate abutting the first optical waveguide;
d) producing a heterogeneously integrated laser chip configured to generate light having a varying frequency, wherein step d) comprises the sub-steps
   d1) providing a second SOI substrate;
   d2) forming a second optical waveguide on or in the second SOI substrate;
   d3) providing a stack of unpatterned functional III-V layers; and
   d4) bonding the stack of unpatterned functional III-V layers to the second SOI substrate by a wafer-bonding process;
e) patterning the functional III-V layers;
f) testing the heterogeneously integrated laser chip to obtain a testing result; and
g) if the testing result is positive, flip chip bonding the heterogeneously integrated laser chip to a bottom of the trench in the first SOI substrate so that the second optical waveguide is butt coupled to the first optical waveguide.

### BRIEF DESCRIPTION OF THE DRAWINGS

Various features and advantages of the present invention may be more readily understood with reference to the following detailed description taken in conjunction with the accompanying drawings in which:
- Figure 1: is a schematic side view of a vehicle approaching an object which is detected by a scanning device according to the invention;
- Figure 2: is a top view of the scanning device shown in Figure 1;
- Figure 3: illustrates, in a very simplified manner, the basic operation of an FMCW distance measuring device;
- Figure 4: is a graph illustrating the time dependency of the frequency of the light emitted by a light source that is contained in the scanning device;
- Figure 5: is a schematic illustration of important components of the scanning device;
- Figure 6: schematically illustrates how scanning is achieved in the device shown in Figure 5;
- Figure 7: is a schematic top view of a photonic integrated circuit (PIC) according to an embodiment of the invention;
- Figure 8: is a cross section of a portion of the PIC shown in Figure 7 showing a heterogeneously integrated laser chip flip chip bonded to a SOI substrate;
- Figure 9: is a cross section of a portion of another PIC showing a heterogeneously integrated laser chip and a heterogeneously integrated SOA chip both flip chip bonded to a SOI substrate; and

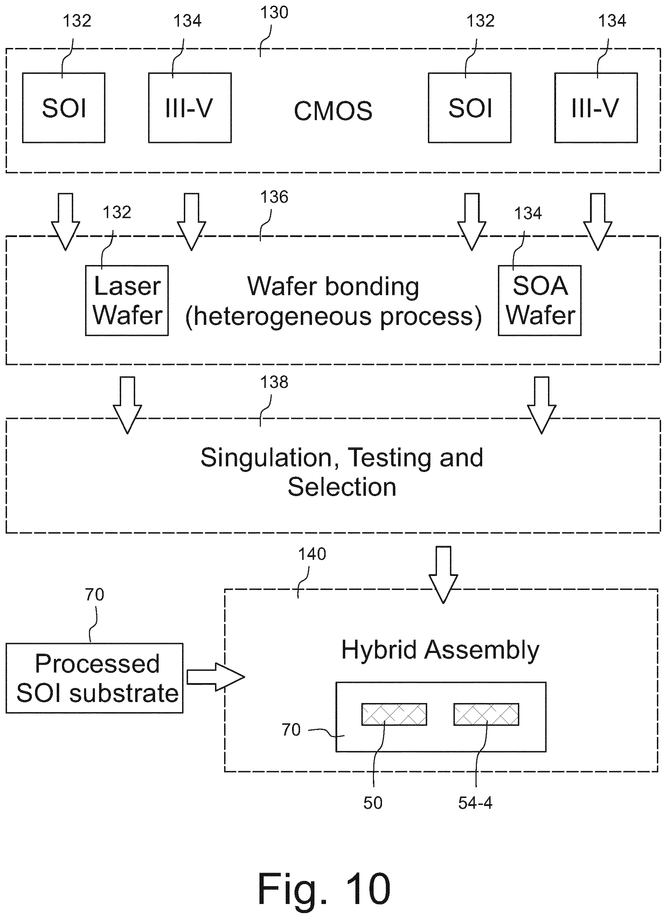

- Figure 10: is a block diagram illustrating important method steps of a manufacturing method in accordance with the present invention.

### DESCRIPTION OF PREFERRED EMBODIMENTS

### 1. Application scenario

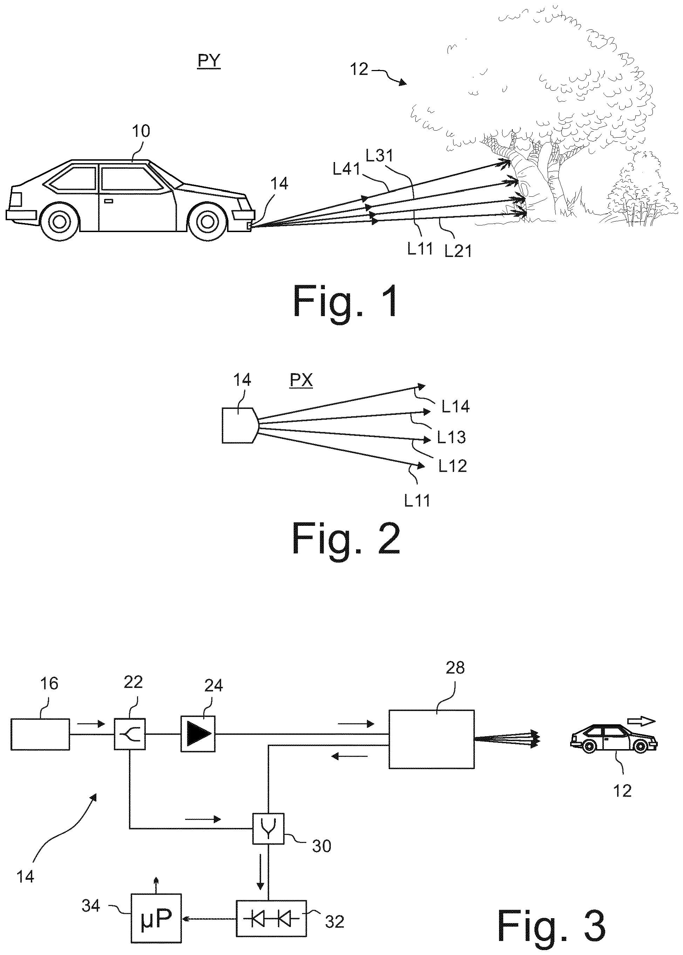

Figure 1 is a schematic side view of a vehicle 10 approaching an object 12 that is represented by a tree. The vehicle 10 has at least one scanning device 14 that uses light beams L11, L21, L31 and L41 to scan the environment ahead of the vehicle 10. From the range information generated by the scanning device 14 a three-dimensional image of the environment can be calculated. In addition, the scanning device 14 determines the relative speed to the object 12. This information is particularly important if the object 12 is another vehicle, an animal or a pedestrian that is also moving.

As can be seen in Figure 1, the scanning device 14 emits light beams L11 to L41 in different directions in a vertical plane (in Figure 1 this is the paper plane) in order to scan the environment in a vertical direction. Scanning also takes place in a horizontal direction, as this is shown in Figure 2 which is a top view on the scanning device 14. Four light beams L11, L12, L13 and L14 are shown which are emitted in different directions in a horizontal plane.

For the sake of clarity, it is assumed in Figures 1 and 2 that only four light beams Ln1 to Ln4 in four different planes - i.e. a total of 16 light beams - are generated by the scanning device 14. In reality, however, the scanning device 14 emits significantly more light beams. For example, k·2ⁿ light beams are preferred, where n is a natural number between 7 and 13 and indicates how many beams are emitted in one of k planes, where k is a natural number between 1 and 16.

### 2. FMCW principle

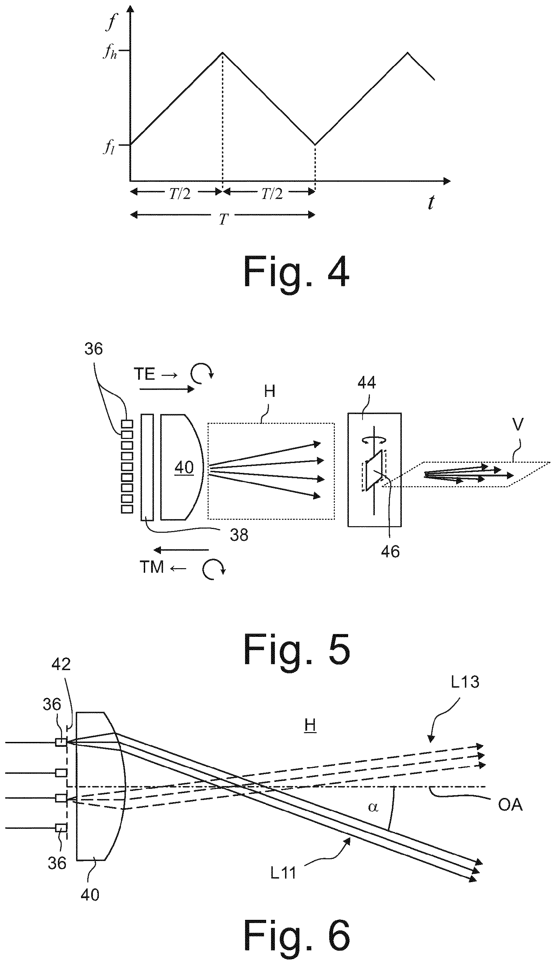

The basic operation of the scanning device 14 will now be explained with reference to Figure 3 that illustrates the main components of such a device in a very schematic manner. The scanning device 14 comprises an FMCW light source 16 which generates measuring light. As shown in Figure 4, the measuring light has a frequency ***f*** that varies ("chirps") periodically over time ***t*** between a lower frequency ***fₗ*** and a higher frequency ***fₕ.*** Each measurement interval with a chirp duration ***T*** is divided into two halves of equal length ***T***/2. During the first interval the frequency ***f*** increases linearly with a constant and positive upchirp rate ***r_{chirp}*** = d***f***/d***t**.* During the second interval, the frequency ***f*** decreases linearly with a constant negative downchirp rate ***-r_{chirp}.*** The frequency of the measured light can thus be described by a periodic triangular function. However, other functional relationships ***f(t)*** such as sawtooth functions are also contemplated.

Referring again to Figure 3, the light source 16 is connected to a splitter 22 which splits the measuring light into reference light (also referred to as local oscillator) and output light. The splitter has an asymmetrical splitting ratio so that only a small fraction of the measuring light is split off as reference light. In the illustrated embodiment, the output light is amplified by an optical amplifier 24. The amplified output light then enters a scanning unit 28 which deflects the output light into various directions, thereby scanning the environment ahead of the device 14.

The output light emitted by the scanning unit 28 is, at least to some extent, diffusely reflected at the object 12, which is represented in Figure 3 by a moving car. In a monostatic design, a small portion of the reflected light returns to the scanning unit 28 and enters the same optical waveguide from which it was emitted; in a bistatic design this portion enters a different optical waveguide that may be located in a separate housing. An example of a bistatic design is described in WO 2023/104297 A1.

This small portion of the reflected light is guided to a combiner 30 where the reflected light superimposes with the reference light provided by the splitter 22. Since the frequencies of the superimposed light portions are slightly different due to the different optical path lengths, a beat signal is generated which is detected by a balanced photodetector or another type of detector 32. The electrical signals generated by the detector 32 are fed to a calculation unit 34, which calculates the range ***R*** and the relative radial velocity ***v*** to the object 12 based on the detected beat frequencies. Details relating to this calculation are described in US 2021/17359319 A1, for example.

### 3. Scanning

Figure 5 illustrates how scanning is achieved in the scanning device 14. The diverging light beams emitted by the selected free-space coupler 36 pass a polarizer 38, whose significance will be explained in the next section, a collimating optical system 40, which is represented in Figure 5 by a single lens element but may comprise more than one lens or other optical elements. In Figure 6, it is illustrated that the free-space couplers 36 are arranged in a front focal plane (which may also be slightly curved) 42 of the collimating optical system 40. Thus, the diverging light beams leave the collimating optical system 40 well collimated and with an angle α with respect to an optical axis OA of the collimating optical system 40. This angle α depends on the distance of the emitting free-space coupler 36 from the optical axis OA.

The emitted light beams L11, L13 shown in Figure 6 propagate in a horizontal plane H, as this is shown in Figures 5 and 6. For scanning in a vertical plane V, a conventional mechanical scanner 44 comprising a rotating or oscillating mirror 46 may be used, see Figure 5. In other embodiments, the free-space couplers are not arranged along a line but form a two-dimensional array. In this case, no mechanical scanner 44 for the vertical scan direction V is required.

### 4. PIC Design

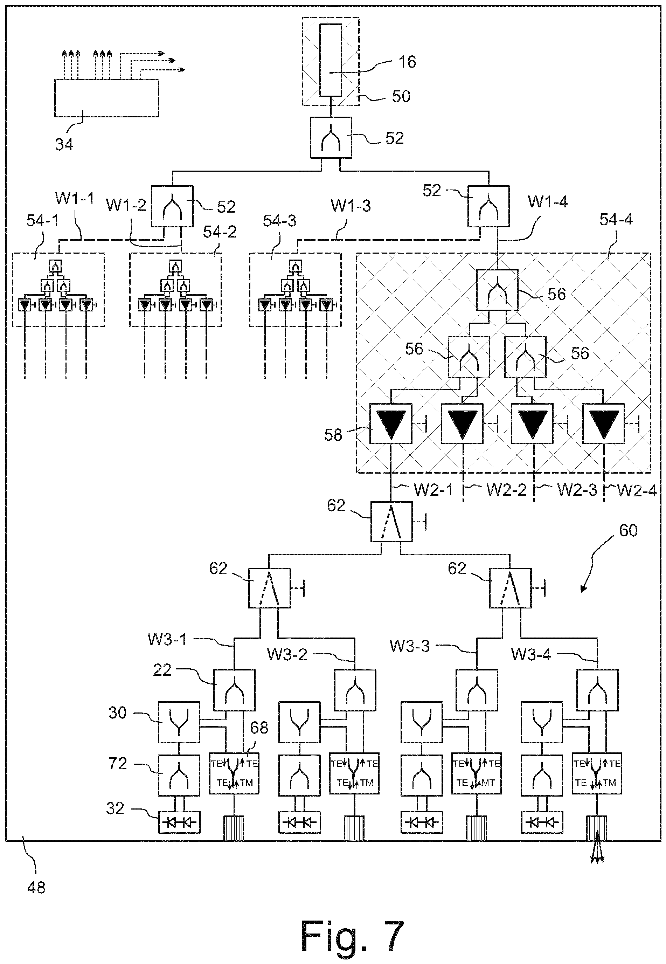

Figure 7 is a schematic top view of a photonic integrated circuit (PIC) 48 according to an embodiment in which the PIC 48 includes all of the components explained above except the quarter-wave plate 38, the collimating optical system 40 and the mechanical scanner 44.

The FMCW light source 16 is implemented as a laser chip 50 that is flip chip bonded to an SOI substrate of the chip 50, as this will be discussed in greater detail in the next section. The PIC 48 further comprises three cascaded passive light splitters 52 that split the measuring light generated by the FMCW light source 16 into four approximately equal portions. Each portion is fed trough optical waveguides W1-1 to W1-4 to one of four semiconductor optical amplifier (SOA) chips 54-1 to 54-4 that are also flip chip bonded to the SOI substrate (see next but section). As shown on the right side of Figure 7, each SOA chip 54-1 to 54-4 contains another set of three cascaded passive light splitters 56 that split the incoming light into four approximately equal portions. Each portion is fed to a semiconductor optical amplifier 58 that amplifies the incoming light. A typical gain of the SOA 58 is between 10 dB and 40 dB, preferably between 20 dB and 30 dB. The other three semiconductor optical amplifier chips 54-1 to 54-3 are identical, but are shown in Figure 7 at a greatly reduced scale for illustrative reasons.

Each semiconductor optical amplifier 58 is connected via one of the optical waveguides W2-1 to W2-4 to a processing unit 60, which is show in Figure 7 only for the semiconductor optical amplifier 54-4. The processing unit 60 comprises a switch matrix having three cascaded optical switches 62 forming a switch tree. The optical switches 62 may be based on the thermo-optical or electro-optical effect, as this is known in the art as such. Thus, an optical signal amplified by one of the semiconductor optical amplifiers 58 may be selectively routed to one of four output channels including waveguides W3-1 to W3-4. In each channel, the asymmetrical passive splitter 22, which may have a splitting ratio of 100:1 or higher, guides the major portion of the optical signal to a polarization dependent splitter 68 and a minor portion of the optical signal to the combiner 30. Examples of suitable polarization dependent splitters 68 are described US 2023/0127941 A1, for example.

The polarization dependent splitter 68 passes the TE polarized signal to a free-space coupler 36 that emits the optical signal to the outside, as described above with reference to Figures 5 and 6. The free-space couplers 36 may be realized as edge couplers or grating couplers, for example. The light emitted by the free-space couplers 36 passes through the polarizer 38 where its TE SOP is converted to a circular SOP, as this is indicated by an arrow above the quarter-wave plate 38 in Figure 5. The emitted light is then deflected by the optical system 40 and finally impinges on the object 12 where a small portion is diffusely reflected. The reflected portion passes again through the optical system 40 and the polarizer 38 wherein its SOP is converted to a TM SOP, as this is indicated by an arrow below the quarter-wave plate 38 in Figure 5. This light portion couples into the free-space coupler 36 and, being now in a TM SOP, is guided by the polarization dependent splitter 68 to the combiner 30, where the light is superimposed with the local oscillator signal which has been split off by the asymmetrical passive splitter 22 from the output light. The superimposed light portions are again split by a symmetrical splitter 72 and finally impinge on the balanced detector 32. The electrical signals produced by the detectors 32 are processed in the calculation unit 34, which is also realized in CMOS technology on the PIC 48.

In the embodiment shown, the processing unit 60 has a monostatic design. Therefore, the light reflected from the object 12 enters the free-space coupler 36, from which it was previously emitted, and propagates along a short waveguide section commonly shared with the transmitted light portion until it reaches the polarization dependent splitter 68. However, bistatic designs are also contemplated. In such designs, the light reflected from the object 12 enters free-space couplers different from the emitting free-space couplers 36 so that no polarization dependent splitters 68 are required. On the other hand, bi-static designs require twice the number of free-space couplers 36 and often additional bulk components arranged outside the PIC.

### 5. Design and Integration of Laser and SOA Chips

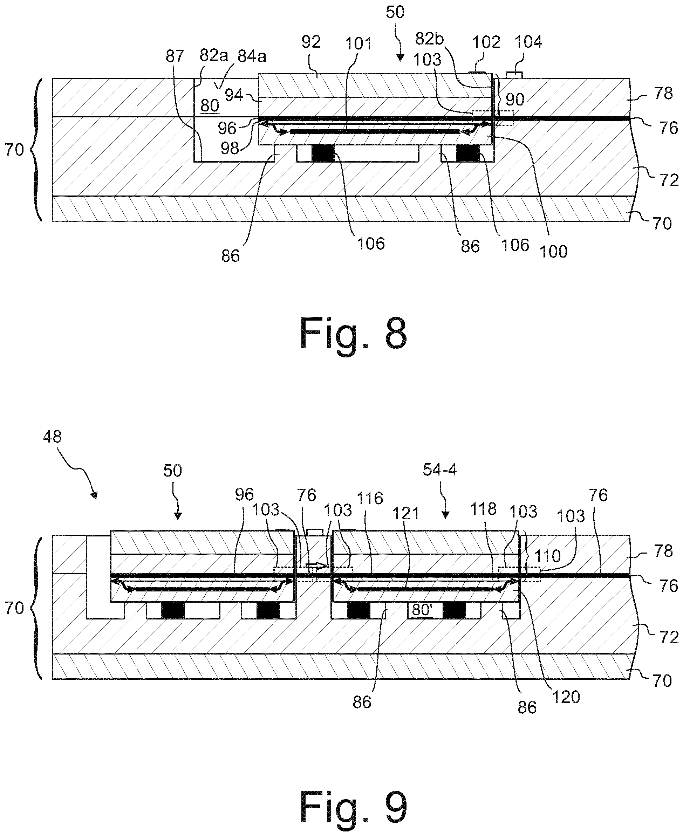

Figure 8 shows a portion of the PIC 48 including the laser chip 50 in a schematic cross-section. The PIC 48 comprises a first SOI substrate 70 having a silicon base layer 72 and a buried insulator layer 74 consisting of SiO₂. The first SOI substrate 70 supports a silicon layer from which a first optical waveguide core 76 is monolithically formed by lithographic patterning, and a cladding layer 78 also consisting of SiO₂. The cladding layer 78 is conventionally also regarded as being part of the SOI substrate 70. A trench 80, which is etched into the first SOI substrate 70, has a first pair of opposing side walls 82a, 82b and a second pair of opposing side walls from which only one designated with 84a can be seen in the cross-section of Figure 8. In other embodiments, the trench 80 has only the pair of opposing side walls 82a, 82b.

The laser chip 50 is received in the trench 80 - upside down as a result of a flip chip bonding step - and rests on pedestals 86 that are elevated from a bottom 87 of the trench 80 and are also lithographically defined. The laser chip 50 is a heterogeneously integrated laser chip and comprises a second SOI substrate 90 having a silicon base layer 92 and a buried insulator layer 94 consisting of SiO₂. The second SOI substrate 90 supports a silicon layer from which a second optical waveguide core 96 is monolithically formed by patterning, and a cladding layer 98 that also consists of SiO₂. The second SOI substrate 90 supports a stack 100 of patterned III-V functional layers forming the semiconductor laser. This stack 100 has been bonded to the SOI substrate 90 by a wafer bonding process, as this is known in the art as such. The stack 100 includes a laser waveguide 101 in which the laser light is generated.

Spot size converters 103 indicated in Figure 8 by dashed rectangles are provided at the end portions of the waveguide cores 76, 96 where the butt coupling occurs. The spot size converters 103 increase the mode field diameter, which significantly improves the coupling efficiency.

Laser light generated in the laser waveguide 101 of the stack 100 evanescently couples into the waveguide core 96 of the second SOI substrate 90. The laser chip 50 is aligned with respect to the first SOI substrate 70 so that the light generated in the laser waveguide 101 and coupled into the second optical waveguide core 96 is butt coupled into the first optical waveguide core 76 buried in the first SOI substrate 70. Vertical alignment of the laser chip 50 is achieved by the pedestals 86, and horizontal alignment is assisted by fiducials 102 provided on the first SOI substrate 70 and fiducials 104 provided on the second SOI substrate 90. Alignment is further enhanced by the use of solder bumps 106 which provide electrical contact between the laser chip 50 and electrical lines provided on the bottom 87 of the trench 80 (not shown).

The hybrid integration of the heterogeneously integrated laser chip 50 combines the advantages of the two integration technologies, namely the ability to test the laser chip 50 before it is attached to the first substrate 70, and the ability to mass produce very efficient laser chips 50 at low cost based on heterogeneous integration that involves a wafer bonding process step.

Figure 9 shows, in a representation similar to Figure 8, an embodiment in which the laser chip 50 and the SOA chip 54-4 are at close distance. The SOA chip 54-4 has shown here has essentially the same design as the laser chip 50, i.e. it includes a third SOI substrate 110 supporting a silicon layer from which a third optical waveguide core 116 is monolithically formed by patterning, a cladding layer 118 and a further stack 120 of patterned III-V functional layers forming the SOA 58 and including an SOA waveguide 121. The stack 120 has been bonded to the third SOI substrate 110 by a wafer bonding process. The third SOI substrate 110 also contains the splitters 56 and other elements (not shown) that are required for a fully functional

SOA chip 54-4. The SOA chip 54-4 is received in a second trench 80' and also rests on pedestals 86.

The three optical waveguide cores 76, 96 and 116 are coaxially aligned in this embodiment so that the light generated in the laser chip 50 butt couples into the first waveguide core 76 and then butt couples into the third waveguide core 116 from which it evanescently couples into the SOA waveguide 121 where the light is amplified. The amplified light evanescently couples back into the third waveguide core 116 and butt couples into another portion of the first waveguide core 76 that is buried in the first SOI substrate. Also in this embodiment, the efficiency of the butt coupling is improved by spot size converters 103 provided at the junctions of the waveguide cores 76, 96 and 116.

It should be noted that many of the above materials may be replaced by other materials. For example, instead of forming the optical waveguide cores 76, 96 from silicon, they may be patterned from silicon nitride (Si₃N₄) or indium phosphide (InP) layers.

### 6. Manufacturing the PIC

Figure is a block diagram illustrating important manufacturing steps that are required to manufacture the PIC 48.

The upper box 130 illustrates the manufacture of unprocessed or partically processed SOI wafers 132 and unprocessed III-V wafers 134 in established CMOS processes.

The box 136 below illustrates the wafer bonding process that is characteristic of heterogeneous integration. In this process, the two wafers 132, 134 are bonded together and only then is the patterning of the stacks 100, 120 of III-V layers performed.

The next box 138 represents a step in which the laser chip 50 and the SOA chips 54-1 to 54-4 are obtained from the wafers 132, 134 by singulation. The singulated chips 50, 54-1 to 54-4 are then tested. Chips that are out of specification are discarded or can be used for applications with less stringent specifications. The remaining chips are selected for use in the final PIC 48.

The next box 140 illustrates the hybrid assembly of the selected chips 50, 54-1 to 54-4 on the first SOI substrate 48 that has been fully processed in a separate CMOS process. During this hybrid assembly, the selected chips 50, 54-1 to 54-4 are flip chip bonded to the first SOI substrate 48.

## Claims

1. A hybrid silicon photonic integrated circuit (48) for an FMCW LIDAR device (14), comprising:
a first SOI substrate (70) having a trench (80),
a first optical waveguide (76) monolithically formed on or in the first SOI substrate (70) and abutting the trench (80),
a heterogeneously integrated laser chip (50) configured to generate light having a varying frequency, wherein the laser chip (50) is received upside down in the trench (80) and comprises:
a second SOI substrate (90) having a second optical waveguide (96) monolithically formed on or in the second SOI substrate (90), the second optical waveguide (96) being aligned and butt coupled to the first optical waveguide (76), and
a stack (100) of patterned functional III-V layers forming a semiconductor laser and supported by the second SOI substrate (90),
wherein the stack (100) of patterned functional III-V layers has been bonded to the second SOI substrate (90) by a wafer bonding process,
a free-space coupler (36) that is monolithically formed on or in the first SOI substrate (70), connected to the laser chip (50) via the first optical waveguide (76) and configured to emit the light generated by the laser chip (50) into free space, and
a detector (32) configured to detect a superposition of reflected light, which was emitted by the free-space coupler (36) and reflected at an object (12) to which a range shall be measured, and reference light, which was not reflected at the object (12).

2. The photonic integrated circuit of claim 1, wherein the first optical waveguide (76) and the second optical waveguide (96) each terminate at a spot size converter (103) configured to enlarge a mode field diameter of light guided in the respective optical waveguide.

3. The photonic integrated circuit of claim 1 or 2, comprising an electrical integrated circuit forming a calculation unit (34) that is configured to determine the range to the object (12) based on the superposition detected by the detector (32).

4. The photonic integrated circuit of any of the preceding claims, comprising electrical contacts arranged at a bottom (86) of the trench (80) and establishing an electrical connection to the laser chip (50).

5. The photonic integrated circuit of any of the preceding claims, comprising alignment structures (86) configured to passively align the laser chip (50) in the trench (80) of the first SOI substrate (70).

6. The photonic integrated circuit of claim 5, wherein the alignment structures are pedestals (86) elevated from a bottom (87) of the trench (80), and wherein the laser chip (50) rests on the pedestals (86).

7. The photonic integrated circuit of any of the preceding claims, wherein a laser waveguide (101) is formed in the stack (100) of patterned functional III-V layers and evanescently coupled to the second optical waveguide (96).

8. The photonic integrated circuit of any of the preceding claims, comprising a first fiducial (104) on the first SOI substrate (70) and a second fiducial (102) on the second SOI substrate (90), wherein the first fiducial (104) is aligned with the second fiducial (102).

9. The photonic integrated circuit of any of the preceding claims, comprising a heterogeneously integrated semiconductor optical amplifier chip (54-4) configured to amplify light generated by the laser chip (50), wherein the semiconductor optical amplifier chip (54-4) is received upside down in the same trench as the laser chip (50) or in a different trench (80') that is also formed in the first SOI substrate (70), wherein the semiconductor optical amplifier chip (54-4) comprises:
a third SOI substrate (110) having a third optical waveguide (116) that is monolithically formed on or in the third SOI substrate (110), the third optical waveguide (116) being aligned and butt coupled to the first optical waveguide (76), and
a further stack (120) of patterned functional III-V layers forming a semiconductor optical amplifier and supported by the third SOI substrate (110),
wherein the further stack (120) of patterned functional III-V layers has been bonded to the third SOI substrate (110) by a wafer-bonding process.

10. The photonic integrated circuit of claim 9, wherein a SOA waveguide (121) is formed in the further stack (121) of patterned functional III-V layers and evanescently coupled to the third optical waveguide (116).

11. The photonic integrated circuit of claim 9 or 10, wherein the semiconductor optical amplifier chip (54-4) has an input port, which is connected to the first optical waveguide, and a plurality of passive light splitters (56) connecting the input port with a plurality of semiconductor optical amplifiers (58).

12. An FMCW LIDAR device for measuring the range to an object, comprising the photonic integrated circuit of any of the preceding claims and a collimating optical system (40) having a front focal plane (42) in which the plurality of free-space couplers (36) are arranged.

13. A method of manufacturing a hybrid silicon photonic integrated circuit for an FMCW LIDAR device (14), comprising the following steps:
a) providing a first SOI substrate (70);
b) forming a first optical waveguide (76) on or in the first SOI substrate (70);
c) forming a trench (80) in the first SOI substrate (70) abutting the first optical waveguide (76);
d) producing a heterogeneously integrated laser chip (50) configured to generate light having a varying frequency, wherein step d) comprises the sub-steps
d1) providing a second SOI substrate (90);
d2) forming a second optical waveguide (96) on or in the second SOI substrate (90);
d3) providing a stack (100) of unpatterned functional III-V layers; and
d4) bonding the stack (100) of unpatterned functional III-V layers to the second SOI substrate (90) by a wafer-bonding process;
e) patterning the functional III-V layers;
f) testing the heterogeneously integrated laser chip (50) to obtain a testing result; and
g) if the testing result is positive, flip chip bonding the heterogeneously integrated laser chip (50) to a bottom (86) of the trench (80) in the first SOI substrate (70) so that the second optical waveguide (96) is butt coupled to the first optical waveguide (76).
